## Europäisches Patentamt

## European Patent Office

## Office européen des brevets

(19)

(11) Publication number: **0 222 278 B1**

# EUROPEAN PATENT SPECIFICATION

(12)

(45) Date of publication of patent specification: **27.03.91**   (51) Int. Cl.⁵: **G01R 19/155**

(21) Application number: **86115140.5**

(22) Date of filing: **31.10.86**

Divisional application 90113317.3 filed on 31/10/86.

(54) **Voltage sensor.**

(30) Priority: **01.11.85 JP 246763/85**
**09.11.85 JP 251495/85**
**09.11.85 JP 251496/85**

(43) Date of publication of application:
**20.05.87 Bulletin 87/21**

(45) Publication of the grant of the patent:
**27.03.91 Bulletin 91/13**

(84) Designated Contracting States:
**DE FR GB**

(56) References cited:
**DE-B- 1 132 653**
**DE-B- 1 134 157**
**FR-A- 1 605 058**
**US-A- 3 383 565**

(73) Proprietor: **ENERGY SUPPORT CORPORATION**
**1, Kamikobari**
**Inuyama-shi Aichi-ken(JP)**

(72) Inventor: **Sometani, Taro**
**1487-45, Koto-cho**
**Hamamatsu-shi Shizuoka-ken(JP)**
Inventor: **Takaoka, Naotoshi**
**1, Kamikobari**
**Inuyama-shi Aichi-ken(JP)**
Inventor: **Aida, Mitsuo**
**2-3, Momogaoka 3-chome**
**Komaki-shi Aichi-ken(JP)**
Inventor: **Kudomi, Mitsuharu**
**Konan Danchi 52-to 201-go 1-8, Fujigaoka 3-chome**
**Konan-shi Aichi-ken(JP)**
Inventor: **Tanahashi, Yasuhiro**
**5, Moto-machi 1-chome**
**Gifu-shi(JP)**
Inventor: **Aoki, Katsunori c/o Company House TAKAMATSU ELECTRIC WORKS, LTD. 42, Nakakobari**
**Inuyama-shi Aichi-ken(JP)**

(74) Representative: **Leyh, Hans, Dr.-Ing. et al**
**Patentanwälte Berendt, Leyh & Hering Innere Wiener Strasse 20**
**W-8000 München 80(DE)**

## Description

The invention relates to a voltage sensor for sensing an alternating voltage of predetermined frequency with reference to ground of an electrically charged object said sensor being disposed with an insulating space toward the electrically charged object, comprising a detection electrode for receiving a displacement current from said object, an inflow section through which the displacement current from said electrically charged object flows into said sensor, a shield electrode having a shape to cover the detection electrode except for said portion of this electrode opposite to said inflow section said shield electrode being made of an electrically conductive material and maintained all times at a reference potential, and a filler of high permittivity.

In US-A-3,383,565 there is disclosed the use of fillers for protecting and sealing sensing electrodes and electronic circuits.

From FR-A-I,605,058 a voltage sensor for sensing a voltage on an electrically charged object is disclosed. This voltage sensor includes an amplifier, an inflow window, a detection electrode and a conducting shield electrode.

Also DE-B-I,134,157 and DE-B-I,132,653 discloses voltage sensors of the above kind.

With respect to this prior art it is an object of the invention to provide a voltage sensor having a simple and compact structure and being protected against water and rain when installed outdoor.

According to the invention this will obtained by the filler surrounding the shield electrode including the inflow section and that the top of the filler being formed into a curved surface for drainage.

A preferred embodiment of this invention will be described by means of the following drawings.

## BRIEF DESCRIPTION OF THE DRAWINGS

Fig. 1 illustrates the structure of a zero-phase-sequence voltage sensing apparatus for distribution lines, showing one embodiment of this invention;

Fig.2 is a cross-sectional view of the voltage sensor with a curved upper surface.

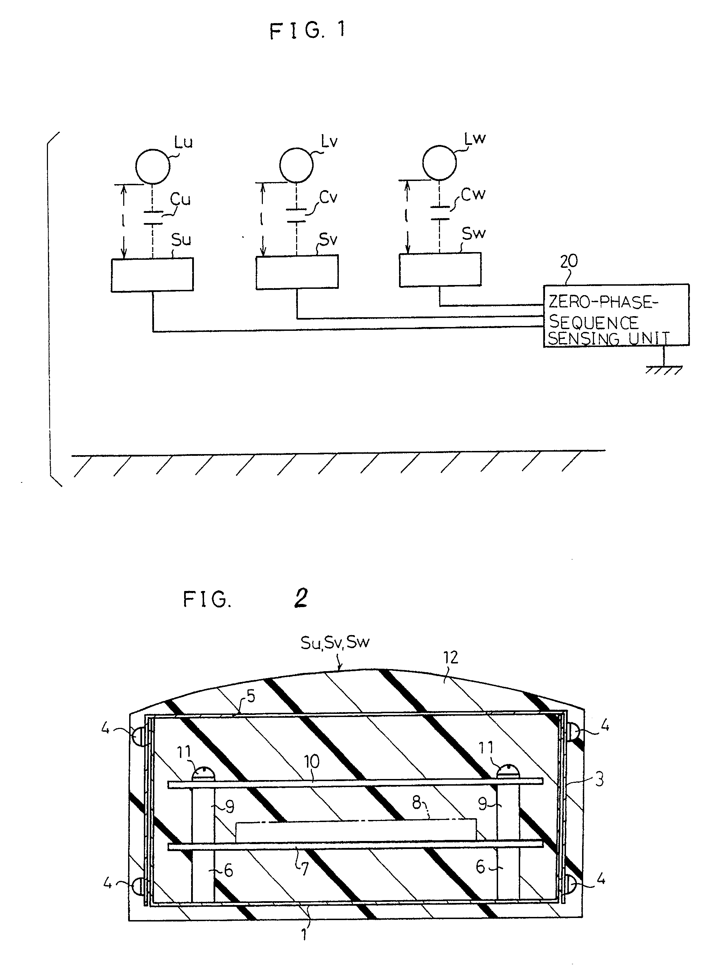

As shown in Figs. 1 and 2 a plurality of voltage sensors Su, Sv and Sw having the same structure are disposed at approximately equal distances of insulation space from the corresponding phase distribution lines Lu, Lv and Lw. A case 1 is provided forming part of a housing of each of the sensors Su, Sv and Sw. An inverted channel-like cover 3 is secured fixedly to the case 1 by screws 4 inserted through both end walls of the cover. A window 5 through which a displacement current flows into the housing (hereinafter referred to as the "displacement current inflow section") is provided in the top of the cover 3. The housing including case 1 and cover 3 is made of an electrically conductive material such as aluminium and functions as a shield electrode for a detection electrode 10.

As shown in Fig. 2, fixed to the bottom of the case 1 through supports 6 is a base plate 7 on which is provided a signal processing circuit 8. The plate-like collection electrode, into which a displacement current flows, or detection electrode 10 is secured fixedly by means of screws 11 to upper ends of spacers 9 upstanding from the base plate 7. Thus the detection electrode 10 is disposed parallel to the upper surface of cover 3 and covered with and isolated from the case 1 and cover 3 except for that portion of electrode 10 opposite to the window 5.

The detection electrode 10 is made of an electrically conductive material of metal, conductive resin, conductive rubber or the like. In this embodiment, aluminium easy to work is used. After the base plate 7 and detection electrode 10 are assembled, the case 1 is filled up with a filler 12 of high permittivity.

The filler 12 is filled not only into the case 1 and cover 3 but also molded so as to surround the case 1 and cover 3 with the top of the molding being formed into a curved surface circular arc-like in cross section. Thus when this sensor is installed outdoors, high-permittivity rainwater is prevented from collecting on the upper surface of the sensor, so that the sensing sensitivity of the sensor is maintained constant.

It should be noted that while the top of the molding is formed curved, it is not limited to the specific shape shown. The top of the molding is only required to have a shape to remove rainwater therefrom.

## Claims

1. A voltage sensor for sensing an alternating voltage of predetermined frequency with reference to ground of an electrically charged object (Lu, Lv, Lw), said sensor being disposed with an insulating space toward the electrically charged object, comprising a detection electrode (l0) for receiving a displacement current from said object, an inflow section (5) through which the displacement current from said electrically charged object flows into said sensor, a shield electrode (1, 3) having a shape to cover the detection electrode (10) except for said portion of this electrode (10) opposite to said inflow section (5), said shield electrode (1, 3) being made of an electrically conductive material and maintained all times at a reference potential, and a filler (12) of high permittivity, characterized in that the filler (12) surrounds the shield electrode (1, 3) including the inflow section (5), and that the top of the filler (12) is formed into a curved surface for drainage.

2. A voltage sensor of claim 1, characterized in that the curved surface of the top of the filler (l2) has a circular arc-like shape or a ridge-roof shape or a slanted shape.

3. A voltage sensor of claim 1, characterized in that the shield electrode (1, 3) includes a housing (1) and a cover (3) and wherein said inflow section being an open window (5) formed in said cover (3).

4. A voltage sensor of claim 3, characterized in that the housing (1) includes a base plate (7) for mounting thereon a signal processing unit (8) on the opposite side of the detection electrode (10) from the open window (5), and that means (9, 11) are provided for fixing the base plate (7) and the detection electrode (10) to the housing (1) at predetermined intervals.

## Revendications

1. Un senseur de tension pour relever une tension alternative d'une fréquence prédéterminée, référée à la masse sur un objet chargé électriquement (Lu. Lv, Lw), et où le senseur comprend une distance d'isolement vers l'objet chargé électriquement, avec une électrode de détection (10) pour recevoir un courant de déplacement de cet objet, avec une section d'entrée (b) à travers de laquelle le courant de déplacement de l'objet chargé électriquement est conduit dans ce secteur, avec une électrode de blindage (1, 3) d'une forme permettant de recouvrir l'électrode de détection (10) à l'exception de cette portion de l'électrode (10) opposée à cette section d'entrée (5) où l'électrode de blindage (1,3) est concu d'un matériau conductif électriquement et maintenu d'une manière permanente à un potentiel de référence, avec un corps remplissant (12) d'une grande permittivité, **caractérisé** en ce que le corps remplissant (12) entoure l'électrode de blindage (1,3) ainsi que la section d'entrée (5) et que la partie supérieure du corps remplissant (12) présente la forme d' une surface courbée pour drainage.

2. Un senseur de tension conformément à la revendication 1 caractérisé en ce que la surface courbée de la partie supérieure du corps remplissant (12) présente une forme d'arc circulaire ou d'arête de toit ou oblique.

3. Un senseur de tension conformément à la revendication 1 caractérisé en ce que l'électrode de blindage (1,3) comprend un boîtier (1) et un recouvrement (3) et où la section d'entrée représente une fenêtre ouverte (5) formée dans ce recouvrement.

4. Un senseur de tension conformément à la revendication 3 caractérisé en ce que le boîtier (1) englobe une platine de base (7) pour permettre le montage d'une unité de traitement des signaux (8) sur le côté opposé de l'électrode de détection (10) par rapport à la fenêtre ouverte (5), puis, des moyens (9,11) pour fixer la platine de base (7) et l'électrode de détection (10) sur le boîtier (1) et ce aux intervalles prédéterminés.

## Ansprüche

1. Spannungssensor zum Messen einer Wechselspannung mit vorgegebener Frequenz relativ zur Erde an einen elektrisch geladenen Gegenstand (Lu, Lv, Lw), wobei der Sensor mit einem Isolierbereich zu dem elektrisch geladenen Gegenstand versehen ist, mit einer Detektorelektrode (10) zum Empfang eines verschiebungsstromes von diesem Gegenstand, einem Eingangsbereich (5), durch welchen der Verschiebungsstrom von dem elektrisch geladenen Gegenstand zu dem Sensor fließt, einer Schutzelektrode (1, 3) mit einer Form, welche die Detektorelektrode (10) abdeckt, außer in dem Bereich der Elektrode (10) gegenüber dem Einlaßbereich (5), wobei ferner die Schutzelektrode (1, 3) aus einem elektrisch leitenden Material besteht und ständig auf einem Bezugspotential gehalten ist, und ferner ein Füllstoff (12) mit hoher Dielektrizitätskonstante vorgesehen ist, dadurch gekennzeichnet, daß der Füllstoff (12) die Schutzelektrode (1, 3) einschließlich des Einlaßabschnittes (5) umschließt und der obere Bereich des Füllstoffes (12) eine gekrümmte Oberfläche hat zur Ableitung von Wasser.

2. Spannungssensor nach Anspruch 1, dadurch gekennzeichnet, daß die gekrümmte Oberfläche des oberen Bereiches des Füllstoffes (12) eine kreisförmige, bogenförmige, eine dachförmige oder eine abgeschrägte Form hat.

3. Spannungssensor nach Anspruch 1, dadurch gekennzeichnet, daß die Schutzelektrode (1, 3) ein Gehäuse (1) und einen Deckel (3) umfaßt und daß der Einlaßabschnitt ein offenes Fenster (5) ist, das im Deckel (3) ausgebildet ist.

4. Spannungssensor nach Anspruch 3, dadurch gekennzeichnet, daß das Gehäuse (1) eine Grundplatte (7) aufweist zur Montage einer Signalprozessoreinheit (8) auf der entgegengesetzten Seite der Detektorelektrode (10) vom offenen Fenster (5) aus, und daß Einrichtungen (9, 11) vorgesehen sind zum Befestigen der Grundplatte (7) und der Detektorelektrode (10) am Gehäuse (1) in vorgegebenen Intervallen.

FIG. 1

FIG. 2

Su, Sv, Sw

ZERO-PHASE-
SEQUENCE
SENSING UNIT